# EUROPEAN PATENT APPLICATION

(11) **EP 4 362 084 A1**
(43) Date of publication of application: **01.05.2024**
(21) Application number: 22203855.6
(22) Date of filing: 26.10.2022
(51) Int. Cl.: H01L 23/495

(54) **A SEMICONDUCTOR DEVICE AND A METHOD FOR MANUFACTURING SUCH SEMICONDUCTOR DEVICE**

(71) Applicant: Nexperia B.V., 6534 AB Nijmegen (NL)
(72) Inventor: Taduran, Arnel, Cabuyao (PH); Yandoc, Ricardo, Manchester, SK7 5BJ (GB); Malveda, Homer, Cabuyao (PH); Dimaano, Antonio, Cabuyao (PH)
(74) Representative: Pjanovic, Ilija

(57) **Abstract**

The disclosure proposes a semiconductor device comprising a lead frame comprising a first lead frame surface and a second lead frame surface, opposite the first lead frame surface, a semiconductor die comprising a first semiconductor die surface and a second semiconductor die surface, opposite the first semiconductor die surface, a clip comprising a flat part and a corrugated part, wherein the corrugated part comprises at least one peak and at least one valley, and a mold compound, wherein the second lead frame surface of the lead frame is connected to the first semiconductor die surface of the semiconductor die, and wherein the second semiconductor die surface of the semiconductor die is connected to the corrugated part of the clip, and wherein the mold compound encapsulates the semiconductor die, and the at least one valley of the corrugated part of the clip, such that the mold compound forms an outer surface of the semiconductor device with at least one peak of the corrugated part of the clip, at least part of the flat part of the clip, and the first lead frame surface of the lead frame exposed.

The disclosure also pertains to a method for manufacturing such semiconductor device.

## Description

### TECHNICAL FIELD

The present disclosure relates to heat dissipation control in power packages. Accordingly a novel method for manufacturing a semiconductor device is proposed, as well as such novel semiconductor device having an improved heat dissipation.

### BACKGROUND OF THE DISCLOSURE

Power package poses concern on heat dissipation, and the majority of MOSFET devices are using either drain or source terminals as exposed heatsink elements attached on a printed circuit board, PCB. Continuous operation of this package will lead to over fatigue on either package or PCB. Mitigating this concern however are already available and various methods has been introduced through dual side cooling (top and bottom part of the package), preventing too much heat absorbed on the PCB through ambient heat dissipation.

Accordingly, it is a goal of the present disclosure to provide a novel power package with an improved heat dissipation.

### SUMMARY OF THE DISCLOSURE

According to a first example of the disclosure, a semiconductor device is proposed, which comprises a lead frame comprising a first lead frame surface and a second lead frame surface, opposite the first lead frame surface, as well as a semiconductor die comprising a first semiconductor die surface and a second semiconductor die surface, opposite the first semiconductor die surface as well as a clip comprising a flat part and a corrugated part, wherein the corrugated part comprises at least one peak and at least one valley.

In particular, the second lead frame surface of the lead frame is connected to the first semiconductor die surface of the semiconductor die, and the second semiconductor die surface of the semiconductor die is connected to the corrugated part of the clip, and a mold compound is used to encapsulate the semiconductor die, and the at least one valley of the corrugated part of the clip, such that the mold compound forms an outer surface of the semiconductor device with at least one peak of the corrugated part of the clip, at least part of the flat part of the clip, and the first lead frame surface of the lead frame being exposed.

The exposed corrugated part and flat part of the clip effectively function as an enlarged heat dissipation surface, in particular at an upper or top face of the semiconductor device. Usually, heat generated during operating the semiconductor device is dissipated from an area with a high (hot) temperature towards an area with a lower (colder) temperature. Thus, the presence of additional heat sink functionality formed by the exposed corrugated part and flat part of the clip provides an additional heat dissipation at the upper surface of the semiconductor device aside from the commonly used heat sink formed by the drain terminal tab. Accordingly, this configuration results in an improved electrical efficiency of the semiconductor device, e.g. formed as a MOSFET or transistor.

In a preferred example, the second lead frame surface of the lead frame is connected to the first semiconductor die surface of the semiconductor die, and/or the second semiconductor die surface of the semiconductor die is connected to the corrugated part of the clip by means of soldering, sintering, or ultrasonic bonding. Soldering is the recommended process according to the example, as this allows for applying a required uniform solder volume, which prevents solder voids and/or insufficient soldering material.

Preferably, the mold compound and the at least one peak of the corrugated part of the clip forms a single planar surface, thus constituting an optimal heat sink surface with improved heat dissipation.

In preferred examples according to the disclosure, the lead frame and/or the clip are made of a conductive metal sheet, for example copper or aluminum.

In particular, wherein the clip is made of a metal sheet, preferably with a width or thickness of 200 µm. Preferably, a width or thickness of the corrugated part is two times the width of the metal sheet. This will provide clip profile close to the top of the package, and allow the mold compound to penetrate on the corrugated part to prevent voiding or delamination.

In order to enlarge the heat dissipating surface of the clip, the corrugated part of the clip comprises at least two peaks, more in particular three or four peaks.

The disclosure also pertains to a method of manufacturing a semiconductor device according to the disclosure. The method may comprise the steps of:
i) forming a clip which comprises a flat part and a corrugated part, wherein the corrugated part comprises at least one peak and at least one valley,
ii) connecting a semiconductor die, which comprises a first semiconductor die surface and a second semiconductor die surface opposite first semiconductor die surface, to a lead frame, which comprises a first lead frame surface and a second lead frame surface opposite the first lead frame surface, such that the second lead frame surface of the lead frame is connected to the first semiconductor die surface of the semiconductor die,
iii) connecting the clip to the semiconductor device such that the second semiconductor die surface of the semiconductor die is connected to the corrugated part of the clip,
iv) encapsulating with a mold compound, such that at least one peak of the corrugated part of the clip, at least part of the flat part of the clip, and the first lead frame surface of the lead frame are exposed.

These method steps result in a semiconductor device wherein the exposed corrugated part and flat part of the clip effectively function as an enlarged heat dissipation surface, in particular at an upper or top face of the semiconductor device.

In a preferred example of the method according to the disclosure, the connecting steps ii) and iii) further comprise the sub-step of:
v) applying a connection by means of soldering, sintering, or ultrasonic bonding between the second lead frame surface of the lead frame and the first semiconductor die surface of the semiconductor die and/or between the second semiconductor die surface of the semiconductor die and the corrugated part of the clip.

Preferably, a soldering connection is performed, as soldering is the recommended process according to the example, as this allows for applying a required uniform solder volume, which prevents solder voids and/or insufficient soldering material.

In a preferred example, the encapsulating step iv) is followed by the step of:
vi) polishing, such that the mold compound and the at least one peak of the corrugated part of the clip forms a single plane surface. This method step results in a semiconductor device with an effective, flat heat sink upper surface with an improved heat dissipation.

In examples of the method according to the disclosure, the clip is made by punching a metal sheet or by forming a metal sheet.

In a final step, the semiconductor device is singulated from the lead frame.

### BRIEF DESCRIPTION OF THE DRAWINGS

The disclosure will now be discussed with reference to the drawings, which show in:
Figures 1a-1d depict in a schematic way the sequence steps of manufacturing an example of a semiconductor device according to the disclosure;
Figures 2a-2g depict in another schematic way the sequence steps of a method of manufacturing a semiconductor device according to the disclosure;
Figure 3 depict an example of a semiconductor device according to the disclosure;
Figures 4a-4d depict in a schematic way the sequence steps of manufacturing an example of an corrugated clip for use in a semiconductor device according to the disclosure.

### DETAILED DESCRIPTION OF THE DISCLOSURE

For a proper understanding of the disclosure, in the detailed description below corresponding elements or parts of the disclosure will be denoted with identical reference numerals in the drawings.

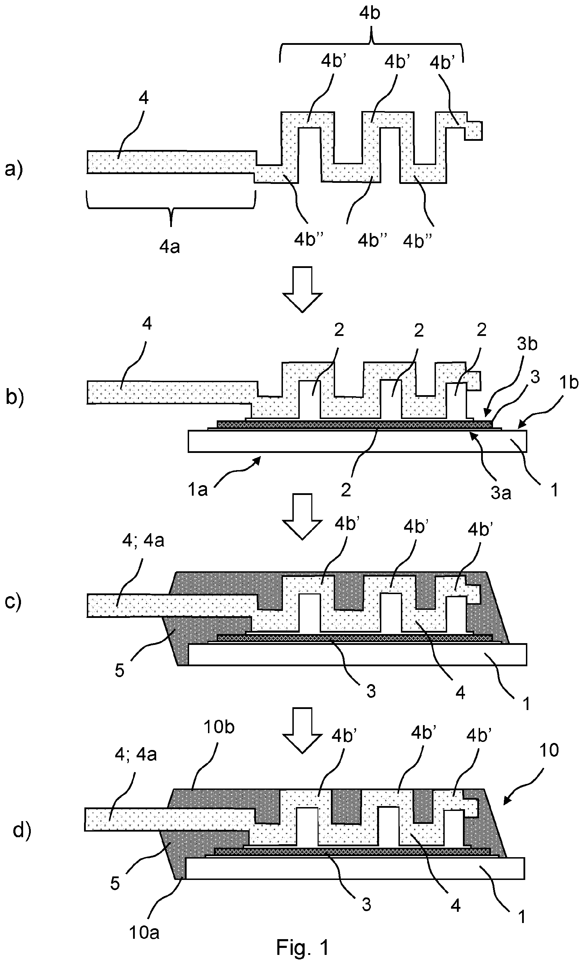

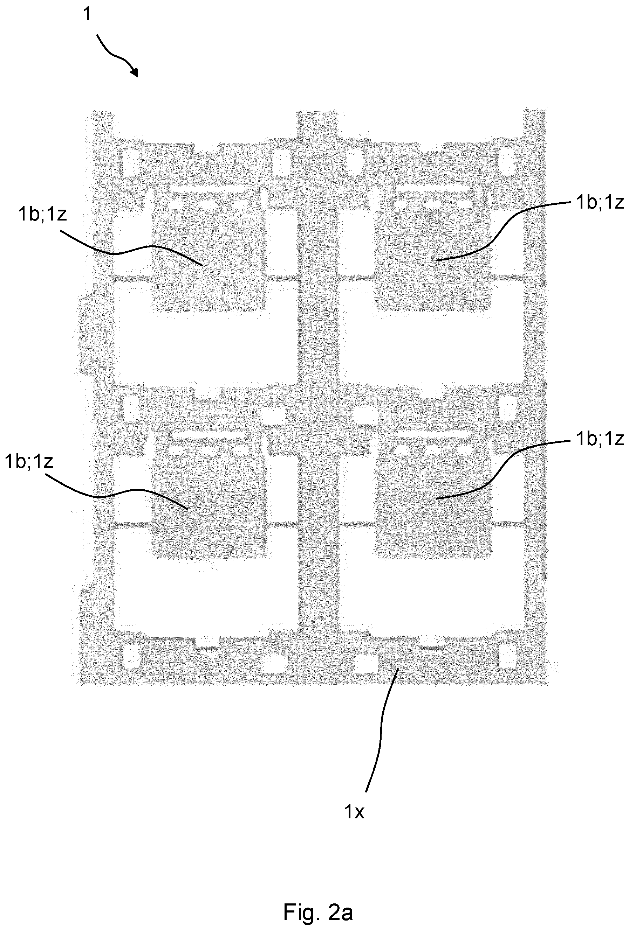

Figures 1a-1d, combined with Figures 2a-2g, depict in a schematic way the sequence steps of manufacturing an example of a semiconductor device according to the disclosure. These sequence steps of the method according to the disclosure present a solution for the ongoing concern on heat dissipation in power packages, such as MOSFET devices. Mitigating this concern it is major a goal of the present disclosure to provide a novel power package with an improved heat dissipation.

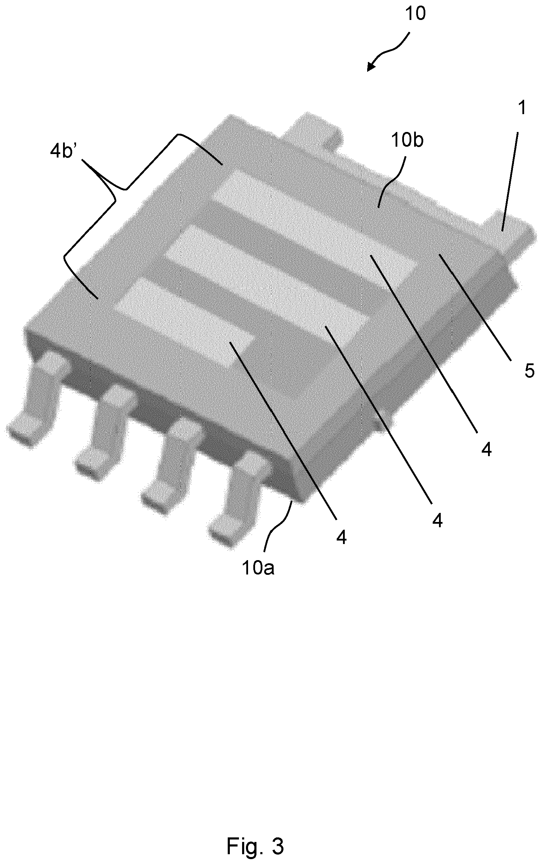

As shown in the various partial views of Figures 1a-1d, also combined with Figure 3, an example of a semiconductor device according to the disclosure is presented. The final package is depicted in Figure 1d and 3, and the semiconductor device is denoted with reference numeral 10. It comprises a lead frame 1 with a first lead frame surface 1a and a second lead frame surface 1b, opposite the first lead frame surface 1a, as well as a semiconductor die 3 comprising a first semiconductor die surface 3a and a second semiconductor die surface 3b, opposite the first semiconductor die surface 3a (Figure 1b). In addition, a clip 4 is implemented, which is composed of a flat part 4a and a corrugated part 4b.

The corrugated part 4b comprises at least one peak 4b' and at least one valley 4b". As shown in the example of e.g. Figure 1a, the corrugated part 4b of the clip 4 comprises at least two peaks 4b', more in particular three peaks 4b'. However more than two peaks 4b' can be used, for example four peaks 4b'. The number of peaks 4b' contribute to an enlargement of the heat dissipating surface of the clip 4.

The second lead frame surface 1b of the lead frame 1 is connected to the first semiconductor die surface 3a of the semiconductor die 3, and the second semiconductor die surface 3b of the semiconductor die 3 is connected to the corrugated part 4b of the clip 4, using a connection technique which will be outlined further in the detailed description.

The complete assembly formed by the semiconductor die 3, the at least one valley 4b" of the corrugated part 4b of the clip 4, and the lead frame 1 are encapsulated by means of a mold compound 5. The encapsulated end product or package 10 is shown in Figure 1d, and shows that after encapsulation the mold compound 5 forms an outer surface of the semiconductor device 10 with at least one peak 4b' of the corrugated part 4b of the clip 4, at least part of the flat part 4a of the clip 4, and the first lead frame surface 1a of the lead frame 1 being exposed.

These exposed elements of the package 10 effectively function as an enlarged heat dissipation surface, in particular at an upper or top face 10b of the semiconductor device 10. Also the exposed first lead frame surface 1a of the lead frame 1 forms the (first) lower surface 10a of the semiconductor device 10 and effectively functions as a drain terminal tab (also denoted with 1a). Usually, heat generated during operating the semiconductor device 10 is dissipated from an area with a high (hot) temperature towards an area with a lower (colder) temperature. Thus, the presence of additional heat sink functionality formed by the exposed corrugated part 4b' and flat part 4a of the clip 4 provides an additional heat dissipation at the upper surface 10b of the semiconductor device 10 aside from the commonly used heat sink formed by the drain terminal tab 1a. Accordingly, this configuration results in an improved electrical efficiency of the semiconductor device 10, e.g. formed as a MOSFET or transistor.

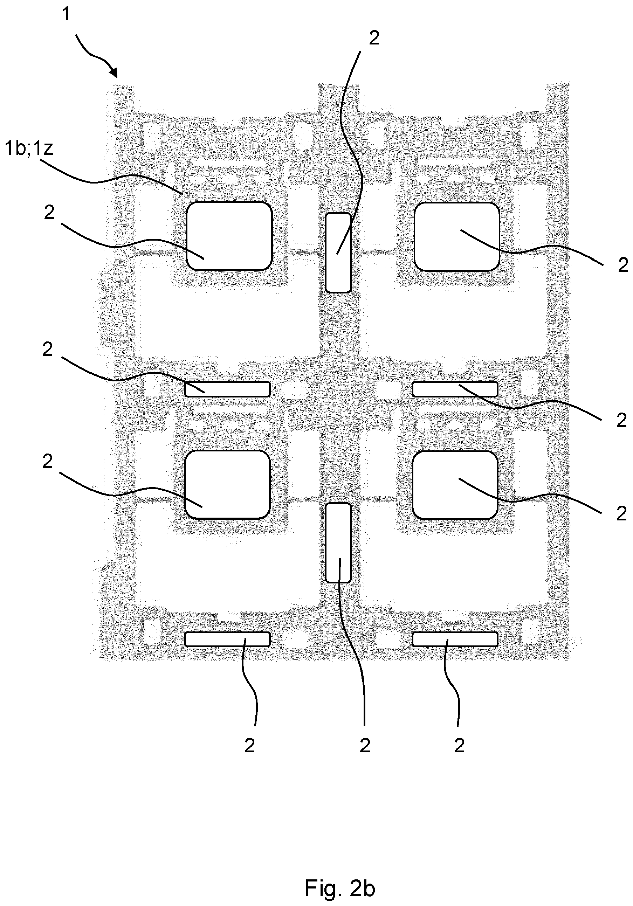

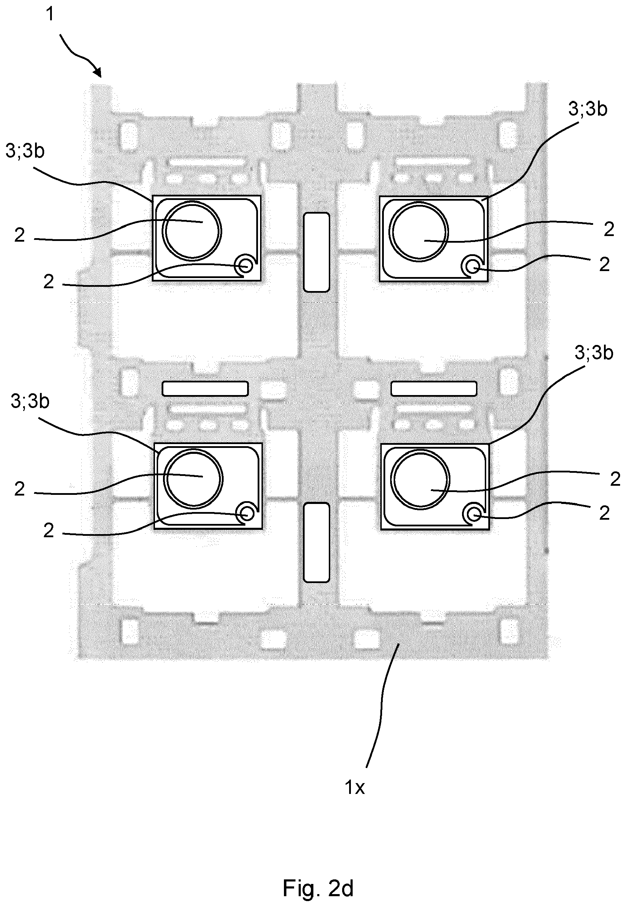

The second lead frame surface 1b of the lead frame 1 is connected to the first semiconductor die surface 3a of the semiconductor die 3, and/or the second semiconductor die surface 3b of the semiconductor die 3 is connected to the corrugated part 4b of the clip 4 by means of soldering, sintering, or ultrasonic bonding. Soldering is the recommended process according to the example, as this allows for applying a required uniform solder volume, which prevents solder voids and/or insufficient soldering material. The connection between the lead frame 1 and the semiconductor die 3, and between the semiconductor die 3 and the clip 4 is schematically shown by means of reference numeral 2 (denoting for example solder paste) in Figure 1b and also in Figures 2b and 2d.

As shown in more detail in Figures 1d and 3, the mold compound 5 and the at least one peak 4b' of the corrugated part 4b of the clip 4 form a single planar (upper) surface 10b of the semiconductor device 10, thus constituting an optimal heat sink surface with improved heat dissipation.

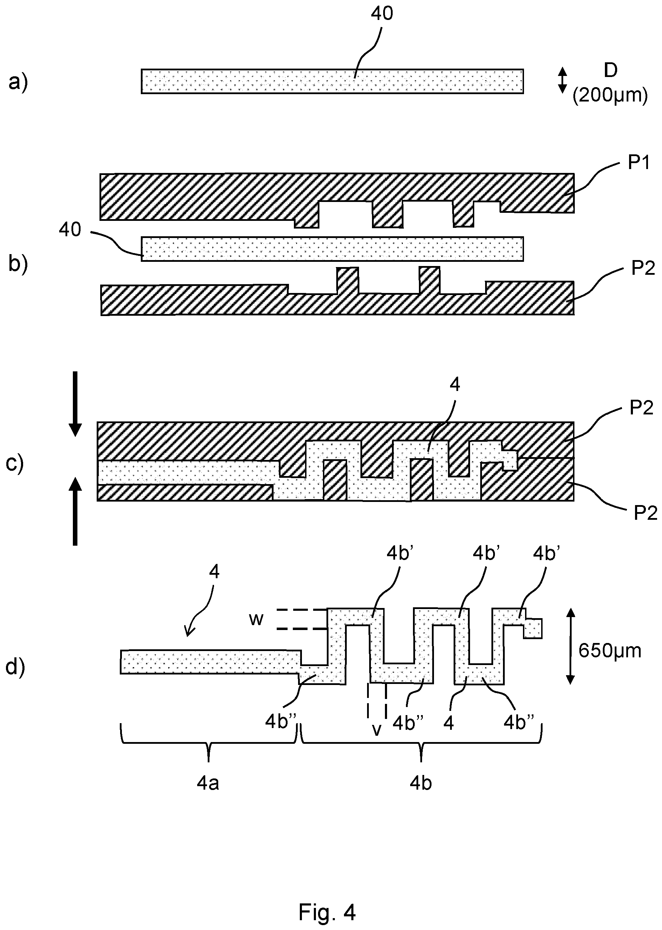

It is preferred that the lead frame 1 and/or the clip 4 are made of a conductive metal sheet, for example copper or aluminum. In particular, in the example of the clip 4 being made of a conductive metal sheet, the sheet has preferably a width of 200 µm, see Figure 4a. Preferably, a width or thickness w of the corrugated part 4b is two times the width/thickness v of the metal sheet in between peaks 4b', see Figure 4d.

Figures 2a-2g combined with Figures 1a-1d and Figures 4a-4d, show the various steps of an example of a method of manufacturing a semiconductor device according to the disclosure.

The method may comprise the steps of forming a clip 4 which comprises a flat part 4a and a corrugated part 4b, wherein the corrugated part comprises at least one peak 4b' and at least one valley 4b". The forming of such clip 4 is depicted in Figures 4a-4b and starts with a starting strip material 40 (Figure 4a) having a certain thickness D, which may be 200 µm. The starting strip material 40 is placed between two preform plates or press dies P1 and P2, which are provided with a preform shape, see Figure 4b. Both press dies P1 and P2 are moved towards each (Figure 4c) and form or punch the starting strip material 40 into the resulting clip 4 (Figure 4d) composed of a flat part 4a and a corrugated part 4b, wherein the corrugated part comprises at least one peak 4b' and at least one valley 4b". As stipulate above, a width or thickness w of the corrugated part 4b is two times the width/thickness v of the metal sheet in between peaks 4b'.

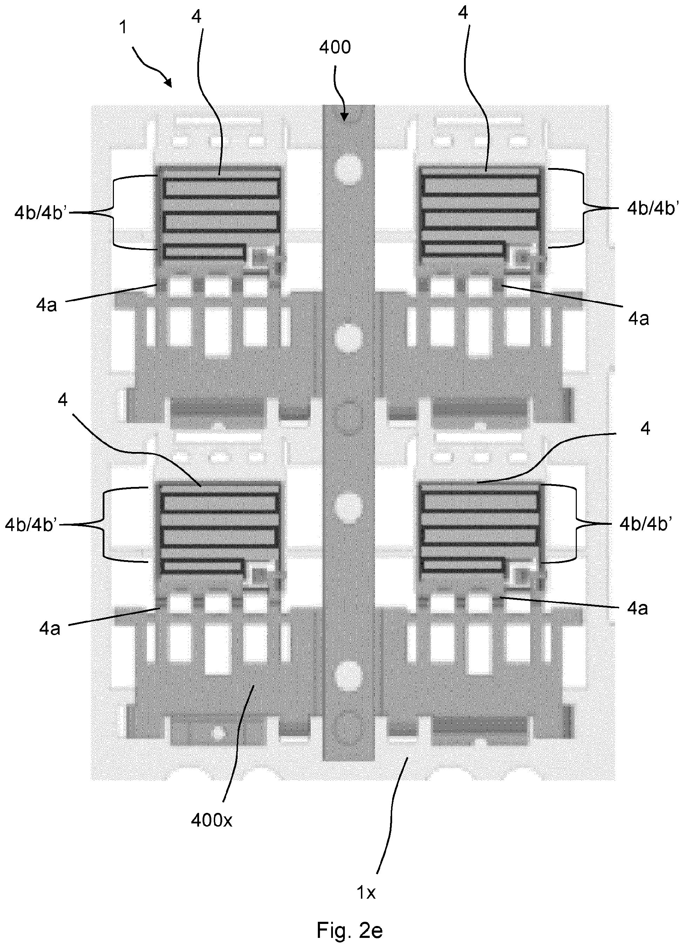

Alternatively, and as shown in Figures 2e-2g, each corrugated clip 4 is accommodated in a so-called clip matrix 400, which contains a plurality of corrugated clips 4.

With the preformed clip 4 thus obtained, the method of manufacturing the semiconductor device 10 continues with the step ii) of connecting a semiconductor die 3 to a lead frame 1. The lead frame 1 is shown in Figure 2a and in particular is depicted as a lead frame matrix (also denoted with reference numeral 1) suited for manufacturing a plurality of semiconductor devices in one sequence. The lead frame 1 is provided with several die attach paddles 1z which function as mounting surface of a semiconductor die 3.

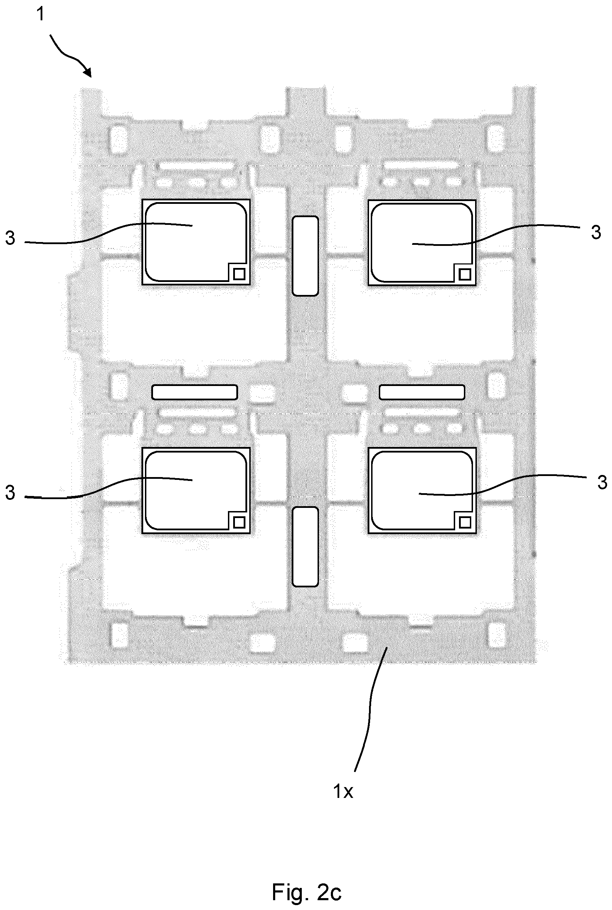

As shown in the Figures, the lead frame 1 comprises a first lead frame surface 1a and a second lead frame surface 1b opposite the first lead frame surface 1a. Likewise, the semiconductor die 3 comprises a first semiconductor die surface 3a and a second semiconductor die surface 3b opposite first semiconductor die surface 3a. When mounting or connecting the semiconductor die 3, see Figure 2c, on a corresponding die attach paddle 1z, the second lead frame surface 1b of the lead frame 1 is connected to the first semiconductor die surface 3a of the semiconductor die 3.

In a next step iii), shown in Figure 2e, the clip 4 is connected to the semiconductor device 3 such that the second semiconductor die surface 3b of the semiconductor die 3 is connected to the corrugated part 4b of the clip 4. Step iii) can be facilitated by mounting the clip matrix 400 containing a plurality of corrugated clips 4 on to the lead frame matrix 1, such that the matrix of individual clips 4 exactly overlap with the plurality of semiconductor dies 3, each mounted to a die attach paddle 1z.

The connecting steps ii) and iii) can be achieved by a multitude of connection techniques, such as soldering, sintering, or ultrasonic bonding between the second lead frame surface 1b of the lead frame 1 and the first semiconductor die surface 3a of the semiconductor die 3 and/or between the second semiconductor die surface 3b of the semiconductor die 3 and the corrugated part 4b of the clip 4.

In the Figures 2b and 2d, these connections are schematically depicted by means of reference numeral 2, which might include a solder paste and solder material. Preferably, a soldering connection is performed, as soldering is the recommended process according to the example, as this allows for applying a required uniform solder volume, which prevents solder voids and/or insufficient soldering material.

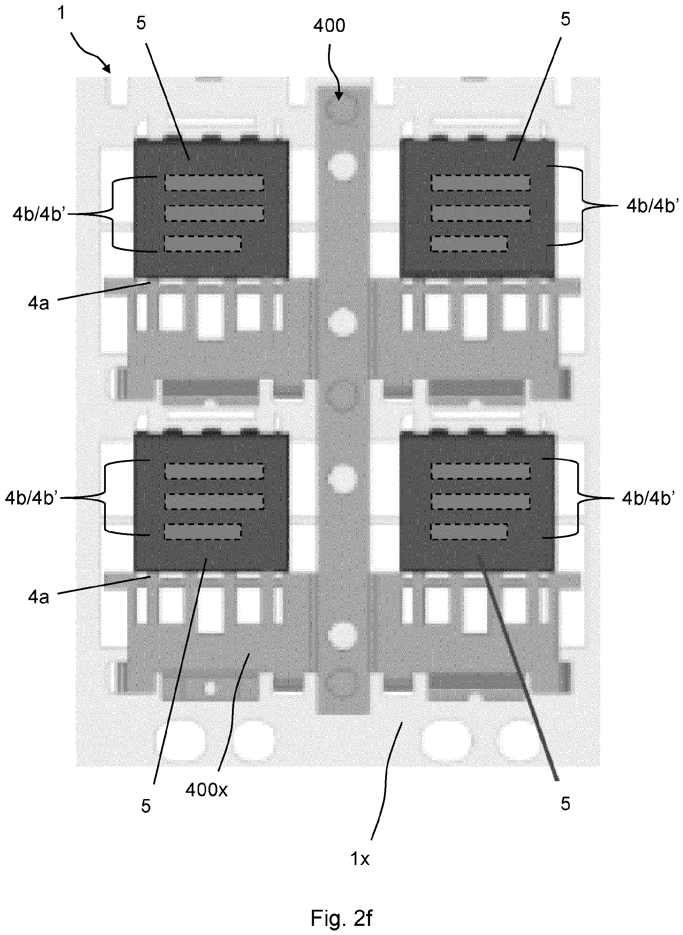

Figure 2f depicts the next method step iv) of encapsulating each assembly formed by the semiconductor die 3, the at least one valley 4b" of the corrugated part 4b of the clip 4, and the lead frame 1 with a mold compound 5. The resulting encapsulant packages are shown in Figure 2f wherein at least one peak 4b' of the corrugated part 4b of the clip 4, at least part of the flat part 4a of the clip 4, and the first lead frame surface 1a of the lead frame 1 are exposed. See also Figures 1d and 3.

Usually, the encapsulating step iv) results in the at least one peak 4b' of the corrugated part 4b of the clip 4 also being covered by the mold compound 5. This is depicted in Figure 1c and also in Figure 2f, wherein the corrugated parts 4b of each clip 4 are covered by mold compound 5, the covering being illustrated by depicting the peaks 4b' by means of dashed lines and with a shading which is slightly lighter than the shading of the mold compound 5.

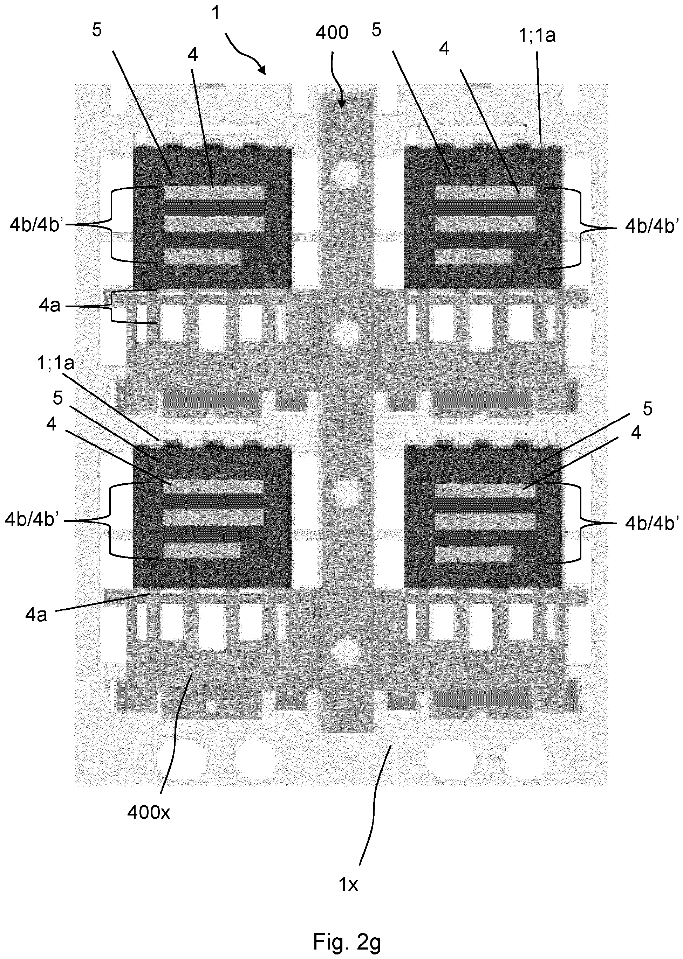

Accordingly, with the peaks 4b' being encapsulated by the mold compound 5, no heat dissipation can be achieved. Thus, the encapsulating step iv) may be followed by a polishing step vi), see Figures 2g and 1d, such that the at least one peak 4b' of the corrugated part 4b of the clip 4 becomes exposed and the mold compound 5 and the at least one peak 4b' of the corrugated part 4b of the clip 4 forms a single plane surface. This results in a semiconductor device with an effective, flat heat sink upper surface 10b with an improved heat dissipation.

In a final step, the semiconductor device is singulated from the lead frame matrix 1 and the clip matrix 400, through removal with known techniques of the excessive lead frame parts 1x and clip matrix parts 400x (see Figure 2g). This results in a singulated semiconductor device 10 (Figure 3) wherein the exposed corrugated part 4b' and flat part 4a of the clip effectively function as an enlarged heat dissipation surface, in particular at an upper or top face 10b of the semiconductor device 10.

### LIST OF REFERENCE NUMERALS USED

- 1: lead frame / lead frame matrix
- 1a: first lead frame surface
- 1b: second lead frame surface
- 1x: excessive lead frame parts
- 1z: die attach paddle
- 2: solder paste / solder material
- 3: semiconductor die
- 3a: first semiconductor die surface
- 3b: second semiconductor die surface
- 4: clip
- 4a: flat part
- 4b: corrugated part
- 4b': peak
- 4b": valley
- 40: starting strip material for clip 4
- 400: clip matrix
- 400x: excessive clip matrix parts
- 5: mould compound
- 10: semiconductor device singulated
- 10a: first, lower surface of semiconductor device
- 10b: second, top or upper surface of semiconductor device
- P1-P2: press plates or press dies

## Claims

1. A semiconductor device comprising:
a lead frame 1 comprising a first lead frame surface 1a and a second lead frame surface 1b, opposite the first lead frame surface 1a;
a semiconductor die 3 comprising a first semiconductor die surface 3a and a second semiconductor die surface 3b, opposite the first semiconductor die surface 3a ;
a clip 4 comprising a flat part 4a and a corrugated part 4b, wherein the corrugated part comprises at least one peak 4b' and at least one valley 4b";
a mold compound 5,
wherein the second lead frame surface 1b of the lead frame 1 is connected to the first semiconductor die surface 3a of the semiconductor die 3, and wherein the second semiconductor die surface 3b of the semiconductor die 3 is connected to the corrugated part 4b of the clip 4, and
wherein the mold compound 5 encapsulates the semiconductor die 3, and the at least one valley 4b" of the corrugated part 4b of the clip 4, such that the mold compound 5 forms an outer surface of the semiconductor device with at least one peak 4b' of the corrugated part 4b of the clip 4, at least part of the flat part 4a of the clip 4, and the first lead frame surface 1a of the lead frame 1 exposed.

2. The semiconductor device according to claim 1, wherein the second lead frame surface 1b of the lead frame 1 is connected to the first semiconductor die surface 3a of the semiconductor die 3 , and/or the second semiconductor die surface 3b of the semiconductor die 3 is connected to the corrugated part 4b of the clip 4 by means of soldering, sintering, or ultrasonic bonding.

3. The semiconductor device according to claim 1 or 2, wherein the mold compound 5 and the at least one peak 4b" of the corrugated part 4b of the clip 4 forms a single planar surface.

4. The semiconductor device according to anyone of the previous claims, wherein the lead frame 1 and/or the clip 4 are made of a conductive metal sheet, for example copper or aluminum.

5. The semiconductor device according to anyone of the previous claims, wherein the clip 4 is made of a metal sheet, preferably with a width of 200 µm, and wherein a width of the corrugated part 4b is two times the width of the metal sheet.

6. The semiconductor device according to anyone of the previous claims, wherein the corrugated part 4b of the clip 4 comprises at least two peaks 4b', more in particular three or four peaks 4b' .

7. A method of manufacturing a semiconductor device according to claim 1-6, comprising steps of:
i) forming a clip 4 which comprises a flat part 4a and a corrugated part 4b, wherein the corrugated part comprises at least one peak 4b' and at least one valley 4b",
ii) connecting a semiconductor die 3, which comprises a first semiconductor die surface 3a and a second semiconductor die surface 3b opposite first semiconductor die surface 3a, to a lead frame 1, which comprises a first lead frame surface 1a and a second lead frame surface 1b opposite the first lead frame surface 1a, such that the second lead frame surface 1b of the lead frame 1 is connected to the first semiconductor die surface 3a of the semiconductor die 3,
iii) connecting the clip 4 to the semiconductor device 3 such that the second semiconductor die surface 3b of the semiconductor die 3 is connected to the corrugated part 4b of the clip 4,
iv) encapsulating with a mold compound 5, such that at least one peak 4b' of the corrugated part 4b of the clip 4, at least part of the flat part 4a of the clip 4, and the first lead frame surface 1a of the lead frame 1 are exposed.

8. The method according to claim 7, wherein the connecting steps ii) and iii) further comprise the sub-step of:
v) applying a connection by means of soldering, sintering, or ultrasonic bonding between the second lead frame surface 1b of the lead frame 1 and the first semiconductor die surface 3a of the semiconductor die 3 and/or between the second semiconductor die surface 3b of the semiconductor die 3 and the corrugated part 4b of the clip 4 .

9. The method according to claim 7 or 8, wherein the encapsulating step iv) is followed by the step of:
vi) polishing, such that the mold compound 5 and the at least one peak 4b' of the corrugated part 4b of the clip 4 forms a single plane surface.

10. The method according to anyone of claims 7-9, wherein the clip 4 is made by punching a metal sheet.

11. The method according to anyone of claims 7-9, wherein the clip 4 is made by forming a metal sheet.

12. The method according to anyone of claims 7-11, further comprising a finalizing step of
singulating the semiconductor device.
